(19) Europäisches Patentamt
European Patent Office
Office européen des brevets

(11) **EP 3 620 606 A1**

(12) **EUROPEAN PATENT APPLICATION**

(43) Date of publication:
**11.03.2020 Bulletin 2020/11**

(51) Int Cl.:
***E21D 20/00*** *(2006.01)*   ***E21D 21/00*** *(2006.01)*

(21) Application number: **19193988.3**

(22) Date of filing: **28.08.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.09.2018 CN 201811036902**

(71) Applicant: **Beijing Jiaotong University Beijing 100044 (CN)**

(72) Inventors:
• **ZHANG, Dingli**
  **Beijing 100044 (CN)**
• **SUN, Zhenyu**
  **Beijing 100044 (CN)**

(74) Representative: **Isern Patentes y Marcas S.L.**
  **Avda. Diagonal, 463 Bis, 2°**
  **08036 Barcelona (ES)**

(54) **DESIGN METHOD AND SYSTEM FOR TUNNEL ANCHORING SYSTEM BASED ON STRUCTURAL CHARACTERISTIC OF SURROUNDING ROCK**

(57)    The present invention discloses a design method and system for a tunnel anchoring system based on a structural characteristic of surrounding rock. The method includes: acquiring a maximum deformation of tunnel surrounding rock and an ultimate deformation of the tunnel surrounding rock; determining whether the maximum deformation of the tunnel surrounding rock is smaller than the ultimate deformation of the tunnel surrounding rock; if yes, normally constructing a tunnel; if not, acquiring a surrounding rock loosening range and an anchor bolt support range; determining whether the surrounding rock loosening range is smaller than the anchor bolt support range; if yes, adopting anchor bolt support only; and if not, adopting anchor bolt and anchor cable collaborative support. The design method or system for a tunnel anchoring system based on a structural characteristic of surrounding rock provided by the present invention can realize scientific and fine tunnel design.

FIG. 4

EP 3 620 606 A1

**Description**

## TECHNICAL FIELD

The present invention relates to the field of tunnel design, and in particular, to a design method and system for a tunnel anchoring system based on a structural characteristic of surrounding rock.

## BACKGROUND

Anchoring systems have been widely used to construct tunnels by tunneling through complex surrounding rock to maintain stability of the tunnel surrounding rock. Tunnel anchoring systems are composed of anchor bolt support and anchor cable support. Engineering practices have shown that they can effectively improve the stress state of the tunnel surrounding rock, have strong capability to control the deformation of the surrounding rock, are suitable for various engineering geological conditions, and have a promising prospect. However, existing design methods neglect the structural characteristic of the tunnel surrounding rock, cannot reflect the influence of the progressive failure behavior of the tunnel surrounding rock on the effect and stress characteristics of the anchoring systems, and lack a method for evaluating the collaborative effect of the anchoring systems. Therefore, at present, the support parameters of the anchoring systems are more determined based on engineering experience. Due to the complexity of tunnel engineering and the variability of surrounding rock conditions, a design scheme of a tunnel anchoring system based on engineering experience often excessively emphasizes on safety and thus leads to material waste under some conditions, and over-emphasizes on economic efficiency and thus causes a large potential safety hazard under other conditions, thus bringing greater security risks to the construction and operation of tunnel engineering.

## SUMMARY

An objective of the present invention is to provide a design method and system for a tunnel anchoring system based on a structural characteristic of surrounding rock, which can realize scientific and fine tunnel design.

To achieve the above purpose, the present invention provides the following technical solution.

A design method for a tunnel anchoring system based on a structural characteristic of surrounding rock includes:

acquiring a maximum deformation of tunnel surrounding rock and an ultimate deformation of the tunnel surrounding rock;

determining whether the maximum deformation of the tunnel surrounding rock is smaller than the ultimate deformation of the tunnel surrounding rock;

normally constructing a tunnel, if the maximum deformation of the tunnel surrounding rock is smaller than the ultimate deformation of the tunnel surrounding rock;

acquiring a surrounding rock loosening range and an anchor bolt support range, if the maximum deformation of the tunnel surrounding rock is greater than or equal to the ultimate deformation of the tunnel surrounding rock;

determining whether the surrounding rock loosening range is smaller than the anchor bolt support range;

adopting anchor bolt support only, if the surrounding rock loosening range is smaller than the anchor bolt support range; and

adopting anchor bolt and anchor cable collaborative support, if the surrounding rock loosening range is greater than or equal to the anchor bolt support range.

Optionally, the adopting anchor bolt support specifically includes:

acquiring a parameter range of anchor bolt support;

optimizing the parameter range by a parameter sensitivity analysis method, to obtain an optimal solution set of anchor bolt support parameters;

determining a deformation of the tunnel surrounding rock under the action of an anchor bolt according to the optimal solution set of anchor bolt support parameters;

determining whether the deformation of the tunnel surrounding rock is smaller than the ultimate deformation of the tunnel surrounding rock;

if yes, determining that the optimal solution set of anchor bolt support parameters are used as anchor bolt support parameters; and

if not, adjusting the parameter range of anchor bolt support, and returning to optimize the parameter range by the parameter sensitivity analysis method, to obtain an optimal solution set of anchor bolt support parameters.

Optionally, the adopting anchor bolt and anchor cable collaborative support specifically includes:

preliminarily formulating a combination scheme through engineering analogy, field measurement and model test methods;

acquiring deformations and collaborative degrees of the surrounding rock in the combination scheme; and determining an optimal combination support scheme according to the deformations and collaborative degrees of the surrounding rock in the combination scheme.

Optionally, the acquiring a maximum deformation of tunnel surrounding rock specifically includes: determining a maximum deformation of the tunnel surrounding rock by a numerical simulation method.

Optionally, the acquiring an ultimate deformation of the tunnel surrounding rock specifically includes:

acquiring a reserved deformation of the tunnel; and determining the ultimate deformation of the tunnel surrounding rock according to the reserved deformation of the tunnel.

To achieve the above purpose, the present invention further provides the following technical solution.

A support system for a tunnel anchoring system based on a structural characteristic of surrounding rock includes:

a first acquisition module, for acquiring a maximum deformation of tunnel surrounding rock;

a second acquisition module, for acquiring an ultimate deformation of the tunnel surrounding rock;

a first determining module, for determining whether the maximum deformation of the tunnel surrounding rock is smaller than the ultimate deformation of the tunnel surrounding rock;

a normal construction module, for normally constructing a tunnel, if the maximum deformation of the tunnel surrounding rock is smaller than the ultimate deformation of the tunnel surrounding rock;

a third acquisition module, for acquiring a surrounding rock loosening range and an anchor bolt support range, if the maximum deformation of the tunnel surrounding rock is greater than or equal to the ultimate deformation of the tunnel surrounding rock;

a second determining module, for determining whether the surrounding rock loosening range is smaller than the anchor bolt support range;

an anchor bolt support determining module, for adopting anchor bolt support only, if the surrounding rock loosening range is smaller than the anchor bolt support range; and

an anchor bolt and anchor cable collaborative support determining module, for adopting anchor bolt and anchor cable collaborative support, if the surrounding rock loosening range is greater than or equal to the anchor bolt support range.

Optionally, the anchor bolt support determining module specifically includes:

an acquisition unit, for acquiring a parameter range of anchor bolt support;

an optimization unit, for optimizing the parameter range by a parameter sensitivity analysis method, to obtain an optimal solution set of anchor bolt support parameters;

a deformation determining unit, for determining a deformation of the tunnel surrounding rock under the action of an anchor bolt according to the optimal solution set of anchor bolt support parameters;

a determining unit, for determining whether the deformation of the tunnel surrounding rock is smaller than the ultimate deformation of the tunnel surrounding rock;

a parameter determining unit, for determining that the optimal solution set of anchor bolt support parameters are used as anchor bolt support parameters, if the deformation of the tunnel surrounding rock is smaller than the ultimate deformation of the tunnel; and

an adjusting unit, for adjusting the parameter range of anchor bolt support, and returning to optimize the parameter range by the parameter sensitivity analysis method, to obtain an optimal solution set of anchor bolt support parameters, if the deformation of the tunnel surrounding rock is greater than or equal to the ultimate deformation of the tunnel.

Optionally, the anchor bolt and anchor cable collaborative support determining module specifically includes:

a scheme formulating unit, for preliminarily formulating a combination scheme through engineering analogy, field measurement and model test methods;

an acquisition unit, for acquiring deformations and collaborative degrees of the surrounding rock in the combination scheme; and

an optimal scheme determining unit, for determining an optimal combination support scheme according to the deformations and collaborative degrees of the surrounding rock in the combined scheme.

Optionally, the first acquisition module specifically includes:
a maximum deformation determining unit, for determining a maximum deformation of the tunnel surrounding rock by a numerical simulation method.
Optionally, the second acquisition module specifically includes:

a reserved deformation acquisition unit, for acquiring a reserved deformation of the tunnel; and
an ultimate deformation determining unit, for determining the ultimate deformation of the tunnel surrounding rock according to the reserved deformation of the tunnel.

According to specific embodiments provided in the present invention, the present invention discloses the following technical effects. The present invention provides a design method for a tunnel anchoring system based on a structural characteristic of surrounding rock, where the method includes: acquiring a maximum deformation of tunnel surrounding rock and an ultimate deformation of the tunnel surrounding rock; determining whether the maximum deformation of the tunnel surrounding rock is smaller than the ultimate deformation of the tunnel surrounding rock; normally constructing a tunnel, if the maximum deformation of the tunnel surrounding rock is smaller than the ultimate deformation of the tunnel surrounding rock; acquiring a surrounding rock loosening range and an anchor bolt support range, if the maximum deformation of the tunnel surrounding rock is greater than or equal to the ultimate deformation of the tunnel surrounding rock; determining whether the surrounding rock loosening range is smaller than the anchor bolt support range; adopting anchor bolt support only, if the surrounding rock loosening range is smaller than the anchor bolt support range; and adopting anchor bolt and anchor cable collaborative support, if the surrounding rock loosening range is greater than or equal to the anchor bolt support range. The present invention is based on a structural characteristic of the tunnel surrounding rock, and can realize collaborative optimization design of the tunnel anchoring system to reduce the subjectivity of tunnel anchoring system design and improve scientificity thereof, and at the same time, can reduce the cost of support as much as possible while ensuring the safety of the tunnel, to meet both economy and safety requirements.

**BRIEF DESCRIPTION OF THE DRAWINGS**

To describe the technical solutions in the embodiments of the present invention or in the prior art more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.

FIG. 1 is a flowchart of a design method for a tunnel anchoring system based on a structural characteristic of surrounding rock according to the present invention;
FIG. 2 is a diagram showing a relative position relation between an anchor bolt and a surrounding rock structure according to Embodiment 1 of the present invention;
FIG. 3 shows an influence of an anchor bolt parameter on a characteristic curve of surrounding rock according to Embodiment 1 of the present invention;
FIG. 4 is a diagram showing a relative position relation between an anchoring system and surrounding rock according to Embodiment 2 of the present invention;
FIG. 5 shows deformations of tunnel surrounding rock in various schemes according to Embodiment 2 of the present invention;
FIG. 6 shows collaborative degrees of an anchoring system in various schemes according to Embodiment 2 of the present invention; and
FIG. 7 is a structural diagram of a support system for a tunnel anchoring system based on a structural characteristic of surrounding rock according to the present invention.

**DETAILED DESCRIPTION**

The following clearly and completely describes the technical solutions in the embodiments of the present invention with reference to the accompanying drawings in the embodiments of the present invention. Apparently, the described embodiments are merely a part rather than all of the embodiments of the present invention. All other embodiments obtained by a person of ordinary skill in the art based on the embodiments of the present invention without creative efforts shall fall within the protection scope of the present invention.

To make objectives, characteristics, and advantages of the present invention more comprehensible, the following describes the present invention in more detail with reference to the accompanying drawings and specific implementations.

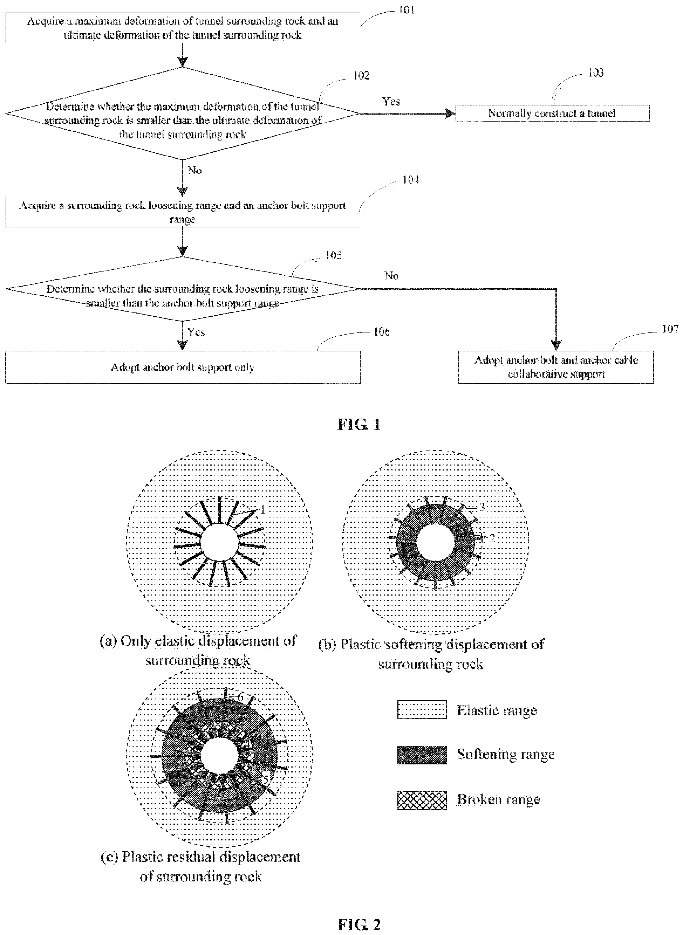

FIG. 1 is a flowchart of a design method for a tunnel anchoring system based on a structural characteristic of surrounding rock according to the present invention. As shown in FIG. 1, a design method for a tunnel anchoring system based on a structural characteristic of surrounding rock, where the method includes:

    step 101: acquire a maximum deformation of tunnel surrounding rock and an ultimate deformation of the tunnel surrounding rock;
    step 102: determine whether the maximum deformation of the tunnel surrounding rock is smaller than the ultimate deformation of the tunnel surrounding rock;
    step 103: normally construct a tunnel, if the maximum deformation of the tunnel surrounding rock is smaller than the ultimate deformation of the tunnel surrounding rock;
    step 104: acquire a surrounding rock loosening range and an anchor bolt support range, if the maximum deformation of the tunnel surrounding rock is greater than or equal to the ultimate deformation of the tunnel surrounding rock;
    step 105: determine whether the surrounding rock loosening range is smaller than the anchor bolt support range;
    step 106: adopt anchor bolt support only, if the surrounding rock loosening range is smaller than the anchor bolt support range; and
    step 107: adopt anchor bolt and anchor cable collaborative support, if the surrounding rock loosening range is greater than or equal to the anchor bolt support range.

The step 106 specifically includes:

    acquire a parameter range of anchor bolt support;
    optimize the parameter range by a parameter sensitivity analysis method, to obtain an optimal solution set of anchor bolt support parameters;
    determine a deformation of the tunnel surrounding rock under the action of an anchor bolt according to the optimal solution set of anchor bolt support parameters;
    determine whether the deformation of the tunnel surrounding rock is smaller than the ultimate deformation of the tunnel surrounding rock;
    if yes, determine that the optimal solution set of anchor bolt support parameters are used as anchor bolt support parameters; and
    if not, adjust the parameter range of anchor bolt support, and return to optimize the parameter range by the parameter sensitivity analysis method, to obtain an optimal solution set of anchor bolt support parameters.

The step 107 specifically includes:

    preliminarily formulate a combination scheme through engineering analogy, field measurement and model test methods;
    acquire deformations and collaborative degrees of the surrounding rock in the combination scheme;
    determine an optimal combination support scheme according to the deformations and collaborative degrees of the surrounding rock in the combination scheme; and
    determine a maximum deformation of the tunnel surrounding rock by a numerical simulation method.

The method of acquiring an ultimate deformation of the tunnel surrounding rock specifically includes:

    acquire a reserved deformation of the tunnel; and
    determine the ultimate deformation of the tunnel surrounding rock according to the reserved deformation of the tunnel.

The method of the present invention has the following advantages:

    1. the structural characteristic of the surrounding rock is predicted according to a geological parameter of tunnel engineering, and a support scheme is initially determined for the tunnel anchoring system (i.e. whether anchor cable support is required) in combination with an existing technical standard;
    2. a deformation control standard is determined according to the provisions of reserved deformations in tunnel design specifications; the relative position relation between the anchor bolt as well as the anchor cable and the surrounding rock is divided into different working conditions, and the stress and deformation of the anchoring system under different working conditions are calculated by means of numerical simulation; and

3. the various support schemes can be determined comprehensively through comparison of collaborative degrees, thus achieving collaborative optimization design of the tunnel anchoring system.

Specific Embodiment 1:

Anchor bolt support design

A deep buried tunnel can be equivalent to a circular tunnel with a radius of $r_0$ = 6m ; the tunnel has a burial depth of 240 m, and a surrounding rock class of IV. The tunnel is in soft rock; the surrounding rock has the following parameters: elastic stage: mechanical parameters such as elastic modulus $E$ = 1.5Gpa, and Poisson ratio $\mu$ = 0.3; softening stage: softening modulus $E'$ = 0.5Gpa, cohesion $c$ = 0.7Mpa, internal friction angle $\varphi$ = 30°, and dilation coefficient $f$ = 2 in a softening range; and residual stage: cohesion $C_r$ = 0.3Mpa, internal friction angle $\varphi_r$ = 22°, and dilation coefficient $h$ = 3.

After numerical analysis and calculation, a maximum surrounding rock displacement after tunnel excavation is 127 mm, a loosening range is 2.36 m, and a deformation control standard of the tunnel surrounding rock is 60 mm according to the provisions of reserved deformations in the specifications; as the loosening range is small, the surrounding rock can be controlled only with bolt support. In order to study the influence of an anchor bolt parameter on a characteristic curve of the tunnel surrounding rock, 7 kinds of working conditions, including anchor bolt diameter (d), arrangement consistency (C), anchor bolt length ($L_s$) and prestress ($F_s$), are analyzed with reference to a parameter range of prestressed anchor bolt support recommended in the specifications; the working conditions are calculated as shown in Table 1.

Table 1 Fluctuation range of anchor bolt parameters

| Anchor bolt parameters | Parameter fluctuation range | | | | | | |
|---|---|---|---|---|---|---|---|
| $d$ (mm) | 16 | 18 | 20 | 22 | 25 | 28 | 30 |
| $C$ (number of anchor bolts/m$^2$) | 0.5 | 0.75 | 1 | 1.25 | 1.5 | 1.75 | 2 |
| $L_s$ (m) | 1.5 | 2 | 2.5 | 3 | 3.5 | 4 | 4.5 |
| $F_s$ (kN) | 15 | 30 | 45 | 60 | 75 | 90 | 105 |

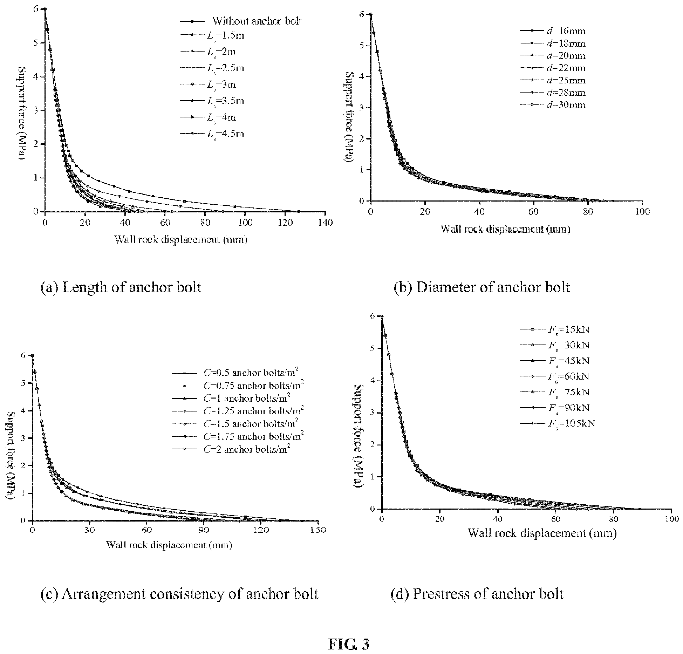

When the influence of a parameter change (except $E_s$) on the characteristic curve of the surrounding rock is studied, the elastic modulus ($E_s$) of the anchor bolt adopts 200 Gpa, and the other parameters adopt the minimums in the 7 conditions. FIG. 2 is a diagram showing a relative position relation between an anchor bolt and a surrounding rock structure according to Embodiment 1 of the present invention. FIG. 3 shows an influence of an anchor bolt parameter on a characteristic curve of surrounding rock according to Embodiment 1 of the present invention. Substituting each working condition in Table 1 into a numerical model corresponding to the relative position relation diagram in FIG. 2 can obtain an influence law of an anchor bolt parameter on the characteristic curve of the surrounding rock in FIG. 3.

It can be seen that when the values of anchor bolt length, diameter, arrangement consistency and prestress increase, surrounding rock displacement decreases, but when the values exceed certain values, the control effect of an anchor bolt on the surrounding rock displacement is not obvious with the change of a parameter. The point with a non-obvious change is called a yielding point; the yielding point is an optimal solution of the parameter, and an optimal solution set of anchor bolt parameters can be obtained as shown in Table 2.

Table 2 Optimal solution set of tunnel anchor bolt parameters

| Length $l$/(m) | Diameter $d$/(mm) | Arrangement consistency $C$/(number of anchor bolts/m$^2$) | Prestress $F$/(kN) |
|---|---|---|---|
| 2.5 | 22 | 1.25 | 60 |

By substituting into the numerical model, the deformation of the tunnel surrounding rock is 38 mm, which is smaller than the deformation control standard of the surrounding rock [u] = 60 mm, and meets construction requirements.

Specific Embodiment 2:

Collaborative optimization design of anchoring system

The surrounding rock parameters selected for calculation are the same as those in Specific Embodiment 1. The difference lies in that the equivalent radius $r_0$ of the tunnel is 10 m, the burial depth is 320 m, the maximum deformation of the surrounding rock is 216 mm by calculation, and the thickness of a loosening circle is 8.35 m, which exceed the anchorage range of anchor bolt support in a rock tunnel. Therefore, anchor bolt and anchor cable combination support is required. Referring to relevant engineering cases, 6 support schemes are preliminarily selected, as shown in Table 3.

Table 3 Calculation/support schemes

| | Main parameters of anchor bolt | | | Main parameters of anchor cable | | |
|---|---|---|---|---|---|---|
| Schemes | Cb (number of anchor bolts/m$^2$) | $L_{sb}$ (m) | $F_{sb}$ (kN) | $C_c$ (number of anchor cables/m$^2$) | $L_{sc}$ (m) | $F_{sc}$ (kN) |
| 1 | 1 | 3 | 60 | 0.25 | 9 | 120 |
| 2 | 1 | 3 | 60 | 0.5 | 9 | 120 |
| 3 | 1 | 5 | 60 | 0.25 | 7 | 120 |
| 4 | 1 | 3 | 80 | 0.25 | 9 | 100 |
| 5 | 1 | 4 | 70 | 0.25 | 11 | 140 |
| 6 | 0.5 | 3 | 70 | 0.5 | 9 | 140 |

It should be pointed out that since the diameter of anchor bolt (cable) support is not obvious to the effect thereof, a collaborative effect of the arrangement consistency, length and prestress of the two is mainly analyzed. For calculation, the diameter of an anchor bolt takes $d_b$ = 22mm, the sectional area of an anchor cable body takes $A_c$ = 560mm$^2$, the elastic modulus of the anchor bolt takes $E_b$ = 200Gpa, and the elastic modulus of an anchor cable takes $E_c$ = 195Gpa.

In order to quantitatively describe the range, conditions and influencing factors of the collaborative effect of the anchor bolt and the anchor cable, a collaborative degree is defined as $\eta$, which can be expressed by the following formula:

$$\eta = \xi_b w_b + \xi_c w_c \qquad (1)$$

In the formula, $W_b$ and $W_c$ are respectively the weight of the anchor bolt and the anchor cable; $W_b$ and $W_c$ can be obtained by such means as an engineering analogy method and an analytic hierarchy process, and can take 0.6 and 0.4 respectively with reference to relevant engineering cases; $\xi_b$ and $\xi_c$ are respectively the average utilization ratio of the anchor bolt and the anchor cable, and are defined as a material's ratio of maximum axial force to ultimate strength, i.e.

$$\xi_i = F_{b,cmax} / F_{t_{b,c}} \qquad (2)$$

In the formula, $F_{t_{b,c}}$ is an ultimate tensile strength of the anchor bolt (cable).

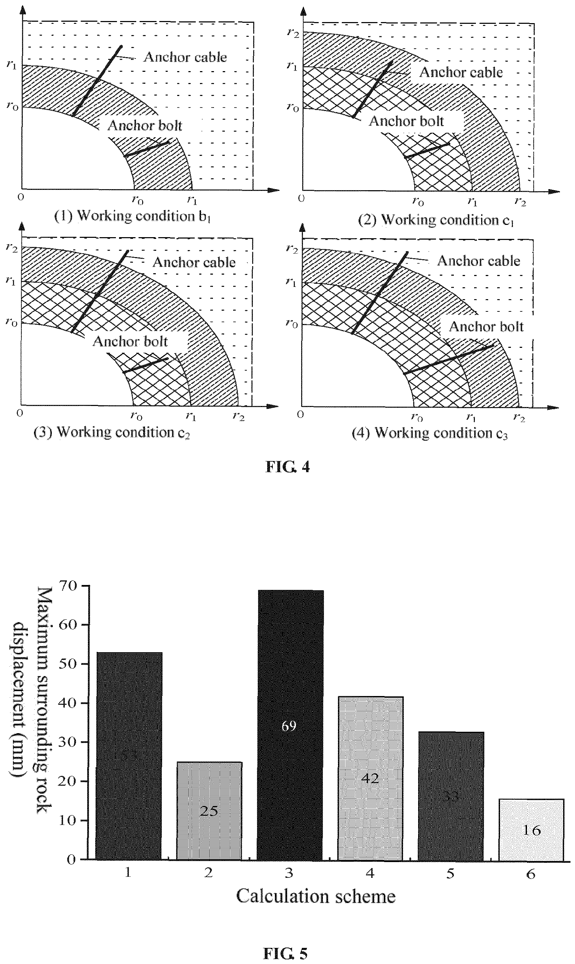

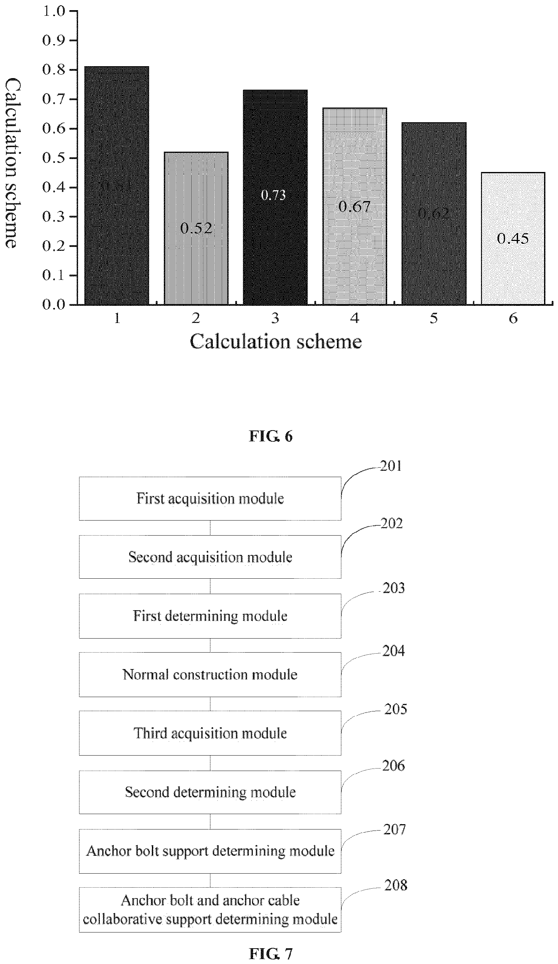

FIG. 4 is a diagram showing a relative position relation between an anchor bolt as well as an anchor cable and a surrounding rock structure according to Embodiment 2 of the present invention. FIG. 5 shows deformations of tunnel surrounding rock in various schemes according to Embodiment 2 of the present invention. FIG. 6 shows collaborative degrees of an anchor bolt and an anchor cable in various schemes according to Embodiment 2 of the present invention.

A maximum displacement of a tunnel surrounding can be obtained by substituting the parameters of various schemes in Table 3 into the numerical model corresponding to the relative position relation diagram of the anchor bolt, the anchor cable and the surrounding rock in FIG. 4.

Scheme 1 is a calculation scheme with the best collaborative effect, and Scheme 6 is one with the worst collaborative effect, indicating that the collaborative degree of the anchoring system is not necessarily large when the deformation control effect of the surrounding rock is good. The foregoing analysis shows that the optimal combination scheme in this example is Scheme 1, where the deformation of the surrounding rock is 53 mm, which meets construction requirements.

The present invention formulates the control standard based on the existing tunnel design specifications, which is easy to be understood and accepted by a designer; the method can consider the relative position relation between the structural characteristic of the tunnel surrounding rock and the anchoring system to more conform to the actual engineering situation, thereby improving the scientificity of tunnel support design, and being good to avoid waste and eliminate construction safety risks.

FIG. 7 is a structural diagram of a support system for a tunnel anchoring system based on a structural characteristic of surrounding rock according to the present invention. As shown in FIG. 7, a support system for a tunnel anchoring system based on a structural characteristic of surrounding rock, where the system includes:

a first acquisition module 201, for acquiring a maximum deformation of tunnel surrounding rock;

a second acquisition module 202, for acquiring an ultimate deformation of the tunnel surrounding rock;

a first determining module 203, for determining whether the maximum deformation of the tunnel surrounding rock is smaller than the ultimate deformation of the tunnel surrounding rock;

a normal construction module 204, for normally constructing a tunnel, if the maximum deformation of the tunnel surrounding rock is smaller than the ultimate deformation of the tunnel surrounding rock;

a third acquisition module 205, for acquiring a surrounding rock loosening range and an anchor bolt support range, if the maximum deformation of the tunnel surrounding rock is greater than or equal to the ultimate deformation of the tunnel surrounding rock;

a second determining module 206, for determining whether the surrounding rock loosening range is smaller than the anchor bolt support range;

an anchor bolt support determining module 207, for adopting anchor bolt support only, if the surrounding rock loosening range is smaller than the anchor bolt support range; and

an anchor bolt and anchor cable collaborative support determining module 208, for adopting anchor bolt and anchor cable collaborative support, if the surrounding rock loosening range is greater than or equal to the anchor bolt support range.

The anchor bolt support determining module 207 specifically includes:

an acquisition unit, for acquiring a parameter range of anchor bolt support;

an optimization unit, for optimizing the parameter range by a parameter sensitivity analysis method, to obtain an optimal solution set of anchor bolt support parameters;

a deformation determining unit, for determining a deformation of the tunnel surrounding rock under the action of an anchor bolt according to the optimal solution set of anchor bolt support parameters;

a determining unit, for determining whether the deformation of the tunnel surrounding rock is smaller than the ultimate deformation of the tunnel surrounding rock;

a parameter determining unit, for determining that the optimal solution set of anchor bolt support parameters are used as anchor bolt support parameters, if the deformation of the tunnel surrounding rock is smaller than the ultimate deformation of the tunnel; and

an adjusting unit, for adjusting the parameter range of anchor bolt support, and returning to optimize the parameter range by the parameter sensitivity analysis method, to obtain an optimal solution set of anchor bolt support parameters, if the deformation of the tunnel surrounding rock is greater than or equal to the ultimate deformation of the tunnel.

The anchor bolt and anchor cable collaborative support determining module 208 specifically includes:

a scheme formulating unit, for preliminarily formulating a combination scheme through engineering analogy, field measurement and model test methods;

an acquisition unit, for acquiring deformations and collaborative degrees of the surrounding rock in the combination scheme; and

an optimal scheme determining unit, for determining an optimal combination support scheme according to the deformations and collaborative degrees of the surrounding rock in the combination scheme.

The first acquisition module 201 specifically includes:
a maximum deformation determining unit, for determining a maximum deformation of the tunnel surrounding rock by a numerical simulation method.

The second acquisition module 202 specifically includes:

a reserved deformation acquisition unit, for acquiring a reserved deformation of the tunnel; and

an ultimate deformation determining unit, for determining the ultimate deformation of the tunnel surrounding rock according to the reserved deformation of the tunnel.

Each embodiment of the present specification is described in a progressive manner, each embodiment focuses on the difference from other embodiments, and the same and similar parts between the embodiments may refer to each other. For a system disclosed in the embodiments, since it corresponds to the method disclosed in the embodiments, the description is relatively simple, and reference can be made to the method description.

Several examples are used for illustration of the principles and implementation methods of the present invention. The description of the embodiments is used to help illustrate the method and its core principles of the present invention. In addition, those skilled in the art can make various modifications in terms of specific embodiments and scope of application in accordance with the teachings of the present invention. In conclusion, the content of this specification shall not be construed as a limitation to the invention.

**Claims**

1. A design method for a tunnel anchoring system based on a structural characteristic of surrounding rock, wherein the method comprises:

   acquiring a maximum deformation of tunnel surrounding rock and an ultimate deformation of the tunnel surrounding rock;
   determining whether the maximum deformation of the tunnel surrounding rock is smaller than the ultimate deformation of the tunnel surrounding rock;
   normally constructing a tunnel, if the maximum deformation of the tunnel surrounding rock is smaller than the ultimate deformation of the tunnel surrounding rock;
   acquiring a surrounding rock loosening range and an anchor bolt support range, if the maximum deformation of the tunnel surrounding rock is greater than or equal to the ultimate deformation of the tunnel surrounding rock;
   determining whether the surrounding rock loosening range is smaller than the anchor bolt support range;
   adopting anchor bolt support only, if the surrounding rock loosening range is smaller than the anchor bolt support range; and
   adopting anchor bolt and anchor cable collaborative support, if the surrounding rock loosening range is greater than or equal to the anchor bolt support range.

2. The design method for a tunnel anchoring system based on a structural characteristic of surrounding rock according to claim 1, wherein the adopting anchor bolt support specifically comprises:

   acquiring a parameter range of anchor bolt support;
   optimizing the parameter range by a parameter sensitivity analysis method, to obtain an optimal solution set of anchor bolt support parameters;
   determining a deformation of the tunnel surrounding rock under the action of an anchor bolt according to the optimal solution set of anchor bolt support parameters;
   determining whether the deformation of the tunnel surrounding rock is smaller than the ultimate deformation of the tunnel surrounding rock;
   if yes, determining that the optimal solution set of anchor bolt support parameters are used as anchor bolt support parameters; and
   if not, adjusting the parameter range of anchor bolt support, and returning to optimize the parameter range by the parameter sensitivity analysis method, to obtain an optimal solution set of anchor bolt support parameters.

3. The design method for a tunnel anchoring system based on a structural characteristic of surrounding rock according to claim 1, wherein the adopting anchor bolt and anchor cable collaborative support specifically comprises:

   preliminarily formulating a combination scheme through engineering analogy, field measurement and model test methods;
   acquiring deformations and collaborative degrees of the surrounding rock in the combination scheme; and
   determining an optimal combination support scheme according to the deformations and collaborative degrees of the surrounding rock in the combination scheme.

4. The design method for a tunnel anchoring system based on a structural characteristic of surrounding rock according to claim 1, wherein the acquiring a maximum deformation of tunnel surrounding rock specifically comprises:
   determining a maximum deformation of the tunnel surrounding rock by a numerical simulation method.

5. The design method for a tunnel anchoring system based on a structural characteristic of surrounding rock according to claim 1, wherein the acquiring an ultimate deformation of the tunnel surrounding rock specifically comprises:

   acquiring a reserved deformation of the tunnel; and
   determining the ultimate deformation of the tunnel surrounding rock according to the reserved deformation of the tunnel.

**6.** A support system for a tunnel anchoring system based on a structural characteristic of surrounding rock, wherein the system comprises:

a first acquisition module, for acquiring a maximum deformation of tunnel surrounding rock;

a second acquisition module, for acquiring an ultimate deformation of the tunnel surrounding rock;

a first determining module, for determining whether the maximum deformation of the tunnel surrounding rock is smaller than the ultimate deformation of the tunnel surrounding rock;

a normal construction module, for normally constructing a tunnel, if the maximum deformation of the tunnel surrounding rock is smaller than the ultimate deformation of the tunnel surrounding rock;

a third acquisition module, for acquiring a surrounding rock loosening range and an anchor bolt support range, if the maximum deformation of the tunnel surrounding rock is greater than or equal to the ultimate deformation of the tunnel surrounding rock;

a second determining module, for determining whether the surrounding rock loosening range is smaller than the anchor bolt support range;

an anchor bolt support determining module, for adopting anchor bolt support only, if the surrounding rock loosening range is smaller than the anchor bolt support range; and

an anchor bolt and anchor cable collaborative support determining module, for adopting anchor bolt and anchor cable collaborative support, if the surrounding rock loosening range is greater than or equal to the anchor bolt support range.

**7.** The support system for a tunnel anchoring system based on a structural characteristic of surrounding rock according to claim 6, wherein the anchor bolt support determining module specifically comprises:

an acquisition unit, for acquiring a parameter range of anchor bolt support;

an optimization unit, for optimizing the parameter range by a parameter sensitivity analysis method, to obtain an optimal solution set of anchor bolt support parameters;

a deformation determining unit, for determining a deformation of the tunnel surrounding rock under the action of an anchor bolt according to the optimal solution set of anchor bolt support parameters;

a determining unit, for determining whether the deformation of the tunnel surrounding rock is smaller than the ultimate deformation of the tunnel surrounding rock;

a parameter determining unit, for determining that the optimal solution set of anchor bolt support parameters are used as anchor bolt support parameters, if the deformation of the tunnel surrounding rock is smaller than the ultimate deformation of the tunnel; and

an adjusting unit, for adjusting the parameter range of anchor bolt support, and returning to optimize the parameter range by the parameter sensitivity analysis method, to obtain an optimal solution set of anchor bolt support parameters, if the deformation of the tunnel surrounding rock is greater than or equal to the ultimate deformation of the tunnel.

**8.** The support system for a tunnel anchoring system based on a structural characteristic of surrounding rock according to claim 6, wherein the anchor bolt and anchor cable collaborative support determining module specifically comprises:

a scheme formulating unit, for preliminarily formulating a combination scheme through engineering analogy, field measurement and model test methods;

an acquisition unit, for acquiring deformations and collaborative degrees of the surrounding rock in the combination scheme; and

an optimal scheme determining unit, for determining an optimal combination support scheme according to the deformations and collaborative degrees of the surrounding rock in the combined scheme.

**9.** The support system for a tunnel anchoring system based on a structural characteristic of surrounding rock according to claim 6, wherein the first acquisition module specifically comprises: a maximum deformation determining unit, for determining a maximum deformation of the tunnel surrounding rock by a numerical simulation method.

**10.** The support system for a tunnel anchoring system based on a structural characteristic of surrounding rock according to claim 6, wherein the second acquisition module specifically comprises:

a reserved deformation acquisition unit, for acquiring a reserved deformation of the tunnel; and

an ultimate deformation determining unit, for determining the ultimate deformation of the tunnel surrounding rock according to the reserved deformation of the tunnel.

Acquire a maximum deformation of tunnel surrounding rock and an ultimate deformation of the tunnel surrounding rock — 101

Determine whether the maximum deformation of the tunnel surrounding rock is smaller than the ultimate deformation of the tunnel surrounding rock — 102

Yes

Normally construct a tunnel — 103

No

Acquire a surrounding rock loosening range and an anchor bolt support range — 104

Determine whether the surrounding rock loosening range is smaller than the anchor bolt support range — 105

No

Yes

Adopt anchor bolt support only — 106

Adopt anchor bolt and anchor cable collaborative support — 107

**FIG. 1**

(a) Only elastic displacement of surrounding rock

(b) Plastic softening displacement of surrounding rock

Elastic range

Softening range

Broken range

(c) Plastic residual displacement of surrounding rock

**FIG. 2**

(a) Length of anchor bolt

(b) Diameter of anchor bolt

(c) Arrangement consistency of anchor bolt

(d) Prestress of anchor bolt

FIG. 3

(1) Working condition $b_1$

(2) Working condition $c_1$

(3) Working condition $c_2$

(4) Working condition $c_3$

FIG. 4

FIG. 5

13

FIG. 6

FIG. 7

Europäisches
Patentamt

European
Patent Office

Office européen
des brevets

## EUROPEAN SEARCH REPORT

Application Number

EP 19 19 3988

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHARLIE C. LI: "Principles of rockbolting design", JOURNAL OF ROCK MECHANICS AND GEOTECHNICAL ENGINEERING, vol. 9, no. 3, 1 June 2017 (2017-06-01), pages 396-414, XP055661769, ISSN: 1674-7755, DOI: 10.1016/j.jrmge.2017.04.002 * figures 6a,6b,7,12,25 * * paragraphs [03.2], [3.2.1], [3.4.2], [04.6] * | 1-10 | INV. E21D20/00 E21D21/00 |

TECHNICAL FIELDS
SEARCHED      (IPC)

E21D

The present search report has been drawn up for all claims

| Place of search | Date of completion of the search | Examiner |
|---|---|---|
| The Hague | 24 January 2020 | Maukonen, Kalle |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)